# EUROPEAN PATENT APPLICATION

(11) **EP 1 995 603 A1**
(43) Date of publication of application: **26.11.2008**
(21) Application number: 08009146.5
(22) Date of filing: 16.05.2008
(51) Int. Cl.: G01R 33/30

(54) **Apparatus of nuclear magnetic resonance measurement for continuous sample injection**

(30) Priority: 21.05.2007 JP 2007134295
(71) Applicant: Hitachi, Ltd., Chiyoda-ku Tokyo 100-8280 (JP)
(72) Inventor: Kitagawa, Isao, Tokyo 100-8220 (JP); Okada, Michiya, Tokyo 100-8220 (JP); Saitoh, Kazuo, Tokyo 100-8220 (JP)
(74) Representative: Strehl Schübel-Hopf & Partner

(57) **Abstract**

A sample tube is used to ensure uniformity in a static magnetic field and uniformity in electromagnetic wave irradiation for NMR measurement for continuous sample injection. The sample tube is formed of a signal detecting tube (330) having a length lying between 80% and 100% of the length of an antenna (200), the signal detecting tube (330) accommodating a sample at the position of the antenna; first and second joint tubes (340,320) each having an outside diameter equal to the outside diameter of the signal detecting tube and having an inside diameter smaller than the inside diameter of the signal detecting tube; and injection and ejection supporting tubes (350,310) each having an inside diameter smaller than the inside diameter of the signal detecting tube. The first and second joint tubes have magnetic susceptibility matched to or brought close to that of a sample solvent.

## Description

### CLAIM OF PRIORITY

The present application claims priority from Japanese application JP 2007-134295 filed on May 21, 2007, the content of which is hereby incorporated by reference into this application.

### BACKGROUND OF THE INVENTION

### 1. Field of the Invention

The present invention relates to an NMR (nuclear magnetic resonance) measurement apparatus and more particularly to an NMR measurement apparatus having a sample tube capable of sample injection and ejection, while maintaining excellent uniformity in a magnetic field and uniformity in an applied electromagnetic wave.

### 2. Description of the Related Art

In NMR measurement, a sample, placed in a uniform static magnetic field produced by a magnet, is irradiated by an antenna with an electromagnetic wave corresponding to the Larmor frequency of nuclear spin contained in the sample, and a free-induction decay (hereinafter referred to as "FID") generated by the nuclear spin is detected by the antenna.

Generally, a method for placement of the sample in the uniform static magnetic field involves first setting up the antenna in space in which magnetic field uniformity suitable for the NMR measurement can be obtained, and fixing within the antenna a sample tube having a target sample put therein. This placement method generally uses the sample tube of a configuration having an opening at one end. This conventional sample tube is often made of a glass material suitable for physical and chemical applications, specifically, fused silica or borosilicate glass. With the conventional sample tube, the sample is generally put in the sample tube so that the sample can maintain a sample volume portion sufficiently longer than the length of the antenna in order to ensure the magnetic field uniformity in the vicinity of the antenna. In this instance, there is a marked deterioration in uniformity in the applied electromagnetic wave at a surplus sample portion that lies outside the antenna, thus causing degradation in the FID signal. To prevent the signal degradation, a shield has hitherto been disposed around the periphery of the antenna or the sample tube in order to suppress the irradiation of the surplus sample portion with the electromagnetic wave and the detection of a signal coming from the surplus sample portion.

On the other hand, several methods have been contrived for purposes of maintenance of the magnetic field uniformity and a reduction in the sample volume. One of the methods involves inserting a substance having a magnetic susceptibility matched to or brought close to the magnetic susceptibility of a sample solvent, into the bottom and top of the sample tube, to thereby coat the top and bottom of the target sample with the substance having the magnetic susceptibility close to that of the sample, thereby maintaining the magnetic field uniformity. Another involves adjusting the magnetic susceptibility of the sample tube in itself, thereby making an attempt to achieve an improvement in the magnetic field uniformity. A glass material having a magnetic susceptibility adjusted to have a value that matches or is close to the magnetic susceptibility of the sample solvent, is used to make the sample tube and a top insert, and thus the top and bottom of the target sample are coated with the substance having the magnetic susceptibility close to that of the sample. (See Japanese Unexamined Patent Application Publication No. Hei 7-84023)

In addition, for nuclear magnetic resonance measurement for continuous sample injection, the sample tube having one or more ports for sample injection and one or more ports for sample ejection is used, a tube is connected to the one or more ports for sample injection or ejection, the sample is fed to the sample tube from outside the magnet, and the sample is ejected after measurement. The sample tube having the injection port and the ejection port is capable of continuous sample injection and ejection and also capable of NMR measurement under a continuous flow of the sample. The sample tube having the injection port and the ejection port is also used for measurement consisting of a combination of high-performance liquid chromatography (hereinafter referred to as "HPLC") and NMR. WO 97/38325 discloses that the sample is fed at a constant flow as much as possible and the volume of the sample tube is reduced, in order to minimize a time width in which components separated by the HPLC are present. The sample tube disclosed in WO 97/38325 has mechanical strength that permits pressure produced by an HPLC system.

### SUMMARY OF THE INVENTION

The conventional sample tube configuration and antenna arrangement requires a sample having a larger volume than the volume of the region in which a signal is to be actually detected, and thus raises measuring costs for measurement of scarce samples or isotope-labeled protein. In addition, the approach of coating the top and bottom of the sample with the substance having the adjusted magnetic susceptibility is effective for measurement where the sample tube containing the sample is placed in the uniform static magnetic field; however, this approach is difficult to apply to the nuclear magnetic resonance measurement for continuous sample injection, in which the sample is injected and ejected directly from the outside. Further, the conventional sample tube has difficulty in ensuring the uniformity in the applied electromagnetic wave and the uniformity in the magnetic field only with the sample tube..

An object of the present invention is to provide an NMR measurement apparatus suitable for NMR measurement for continuous sample injection, using a sample tube having a structure capable of ensuring the uniformity in the static magnetic field and ensuring the uniformity in the applied electromagnetic wave.

The NMR measurement apparatus includes a magnet that produces static magnetic field, an antenna that irradiates a sample with an electromagnetic wave and detects an FID signal originating from the sample, a transmission unit that generates the electromagnetic wave for irradiation, a receive unit that processes the detected FID signal, and a sample tube that places the sample in a location suitable for NMR measurement. For the NMR measurement, it is desirable that the electromagnetic wave for irradiation of the sample be uniform with respect to the sample. If the electromagnetic wave for irradiation is not uniform, nonuniformity occurs in the excited state (the angle of the spin) of nuclear spin detectable with the NMR measurement, which is present within the sample, and thus, a phase shift in the FID signal originating from the nuclear spin occurs. In particular, if there is a sample region in which the strength of the electromagnetic wave for irradiation is 70% or less of the maximum strength, the phase shift causes a reduction in signal strength or noise in multi-dimensional measurement typified by protein measurement.

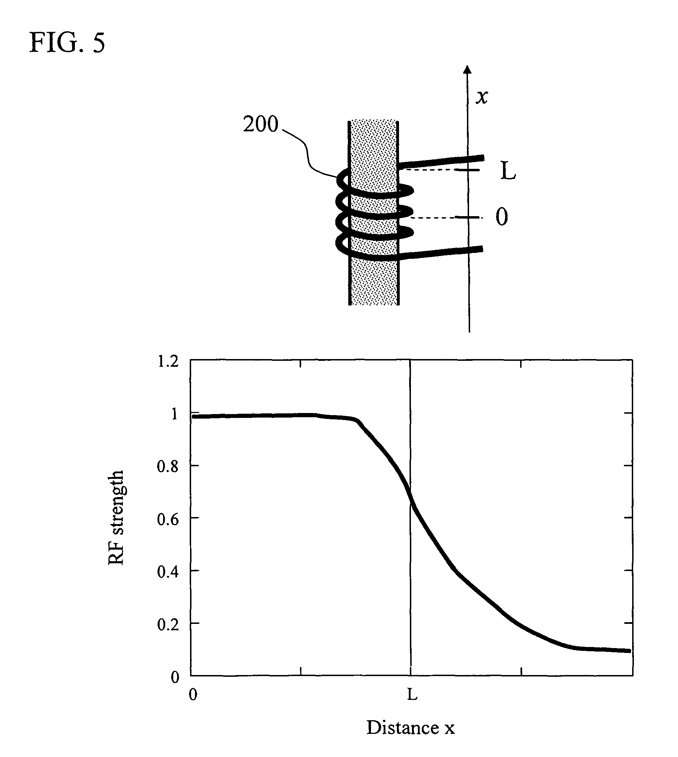

The strength of the electromagnetic wave irradiated from the antenna to the sample depends on the antenna configuration and the relative positions of the antenna and the sample. Fig. 5 shows the relationship between the output strength of the electromagnetic wave for irradiation and the position of the sample using a solenoid coil that is one of typical antenna configurations for use in the NMR measurement. The horizontal axis indicates an axial displacement in the position with respect to an origin that is the center of the antenna 200, and the vertical axis indicates the output strength of the electromagnetic wave for irradiation. As shown in Fig. 5, the output strength of the electromagnetic wave for irradiation sharply decreases before and after the location L of the end of the antenna. In addition, when the position of the sample is far away from the location L of the end of the antenna, the sample receives the electromagnetic wave from the antenna although it is feeble.

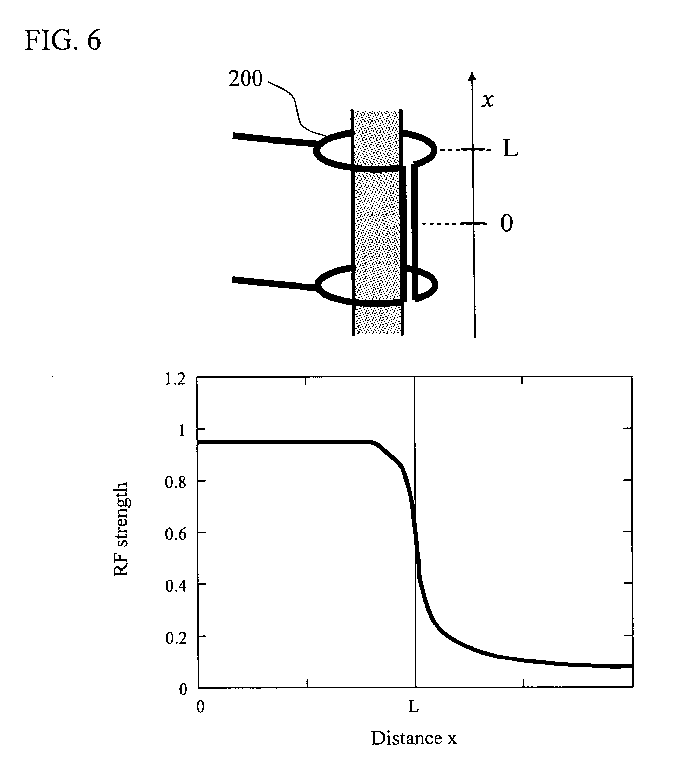

Likewise, Fig. 6 shows the relationship between the output strength of the electromagnetic wave for irradiation and the position of the sample using a saddle coil that is one of the typical antenna configurations for use in the NMR measurement. The horizontal axis indicates an axial displacement in the position with respect to the origin that is the center of the antenna 200, and the vertical axis indicates the output strength of the electromagnetic wave for irradiation. The saddle coil also exhibits the same tendency as the solenoid coil, and the output strength of the electromagnetic wave for irradiation sharply decreases before and after the location L of the end of the antenna. In addition, when the position of the sample is far away from the location L of the end of the antenna, the sample receives the electromagnetic wave from the antenna although it is feeble.

In order to suppress the signal from the sample located farther from the location L of the antenna end, the sample tube configuration in which the sample is not located farther from the location L of the antenna end is implemented to thereby suppress the detection of the FID signal from the region in which the output strength is reduced. In other words, in order that the sample is not present in the region in which the strength of the electromagnetic wave for irradiation is 70% or less, the length of the signal detection tube is less than the length of the antenna, and the signal detection tube is located so as to be covered with the antenna. In addition, in order to prevent a reduction in the strength of the detected signal in proportion to the sample volume, it is preferable that the length of the signal detection tube be 80% or more of the length of the antenna.

Typically, in order to detect a good FID signal, a shim coil built in the magnet is used for adjustment such that the magnetic field produced by the magnet is the uniform static magnetic field. However, the use of the shim coil for adjustment to remove distortion in the magnetic field developed at the interface between the sample and the sample tube takes much time and labor. Therefore, a difference between the magnetic susceptibility of the sample tube portion around the sample and the magnetic susceptibility of the sample (in particular, the sample solvent) is reduced to thereby reduce the distortion in the magnetic field developed at the interface between the sample and the sample tube, thus increase a relaxation time for the detected FID signal, and thus reduce a spectral line width.

In order that the sample tube for use in the NMR measurement for continuous sample injection achieves the configuration in which the sample is not located farther from the location L of the antenna end, the followings are required: (i) the sample is stored within the antenna, and (ii) a portion located in the vicinity of the antenna end and in contact with the sample is formed of a substance having a magnetic susceptibility adjusted to have a value that matches or is close to the magnetic susceptibility of the sample solvent, and a flow channel for sample injection and ejection, which is disposed in the vicinity of the antenna and within the sample tube, is disposed symmetrically with respect to the center of the antenna.

A difference in the magnetic susceptibility at the interface between the sample and the container causes an irregular magnetic field that deteriorates the uniformity in the static magnetic field applied to the sample, and the irregular magnetic field has a magnetic field distribution depending on the shape of the interface. With the sample container having a spherical interface whose center coincides with the center of the sample, the irregular magnetic field has a uniform magnetic field distribution of the lowest order, regardless of the direction. With the sample container having a cylindrical shape that forms a flat interface, the irregular magnetic field has a magnetic field distribution of higher order, involving a sharp change in the magnetic field, depending greatly on the direction, reflecting a sharp interface structure.

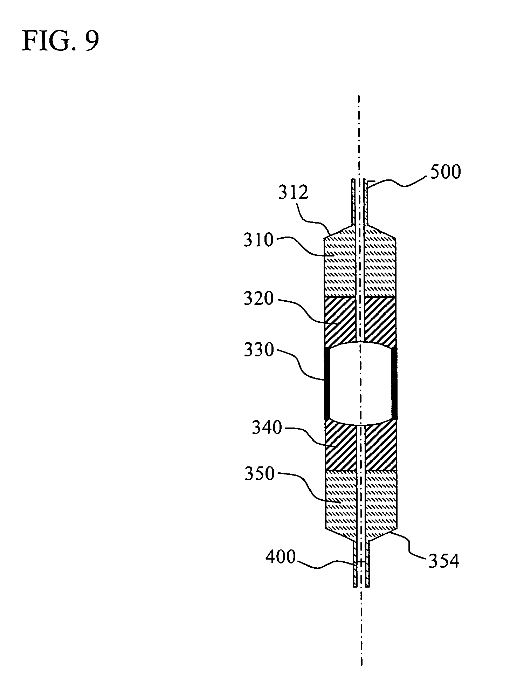

In order to make uniform the magnetic field distribution of the irregular magnetic field, it is necessary to produce the magnetic field having the order and geometrical characteristics equivalent to the produced magnetic field and thereby cancel off the irregular magnetic field. In order to cancel off the magnetic field distribution of higher order, it is required that a shim coil of higher order be prepared for magnetic field adjustment in the vicinity of the sample. However, it is desirable that the irregular magnetic field of higher order be suppressed due to the fact that the number of dimensions of the shim coil is limited and that the magnetic field adjustment using the shim coil of higher order takes much time. Therefore, as shown in Fig. 9, a curved surface structure can be used for the interface between the sample and the container to eliminate a sharpness in the interface and suppress the irregular magnetic field having geometrical characteristics of higher order.

Even if there is a difference in the magnetic susceptibility between the container and the sample solvent, the container using the curved surface structure for the interface between the sample and the container suppresses the irregular magnetic field of higher order, and thus is effective for measurement of the sample that changes in the magnetic susceptibility due to a change in solvent concentration. The NMR measurement for continuous sample injection often includes measurement that involves changing solution conditions, and thus, the container using the curved surface structure for the interface between the sample and the container is effective. The irregular magnetic field distribution of higher order can be suppressed regardless of the magnetic susceptibility of the solvent sample, and thus, the repetition times of magnetic field adjustments for the NMR titration measurement and the time therefor can be reduced.

In addition, the container having the cylindrical shape and flat surface at the interface with the sample may be used for measurement at a constant water concentration (or deuterium oxide concentration) at a constant temperature in which even a change in the solution conditions causes little change in the magnetic susceptibility of the solvent, or the like. The container having the flat interface has the merit of being easy to fabricate and thus reducing manufacturing costs, as compared to the curved surface structure.

The present invention enables the NMR measurement that maintains the uniformity in the static magnetic field for the NMR measurement for continuous sample injection and high uniformity in the electromagnetic wave applied to the sample, and the high uniformity in the applied electromagnetic wave can be achieved regardless of the configuration of the antenna or the presence or absence of an RF shield. In addition, the length of the container that stores the sample required for the NMR measurement is equal to or less than the length of the antenna coil, and this enables a reduction in the target sample.

### BRIEF DESCRIPTION OF THE DRAWINGS

Fig. 1 is a view showing an example of the arrangement of a sample tube and an antenna for a split magnet.
Fig. 2 is a view showing an example of the arrangement of the sample tube and the antenna for an integral magnet.
Fig. 3 is a view showing an example of the configuration of the sample tube.
Fig. 4 is a view showing an example of the configuration of the sample tube and an example of connection to injection and ejection tubes.
Fig. 5 is a graph showing a curve showing the relationship between the distance to a sample and the strength of an applied electromagnetic wave, which is observed in a solenoidal antenna.
Fig. 6 is a graph showing a curve showing the relationship between the distance to the sample and the strength of the applied electromagnetic wave, which is observed in a saddle antenna.
Fig. 7 is a view showing an example of the configuration of the sample tube having injection and ejection ports in the form of an internal thread (or a female thread).
Fig. 8 is a view showing an example of the configuration of the sample tube having an injection supporting tube having plural ports.
Fig. 9 is a view showing an example of the configuration of the sample tube.

### DESCRIPTION OF THE PREFERRED EMBODIMENTS

Description will be given below with regard to preferred embodiments of an apparatus of nuclear magnetic resonance measurement for continuous sample injection of the present invention.

### [First embodiment]

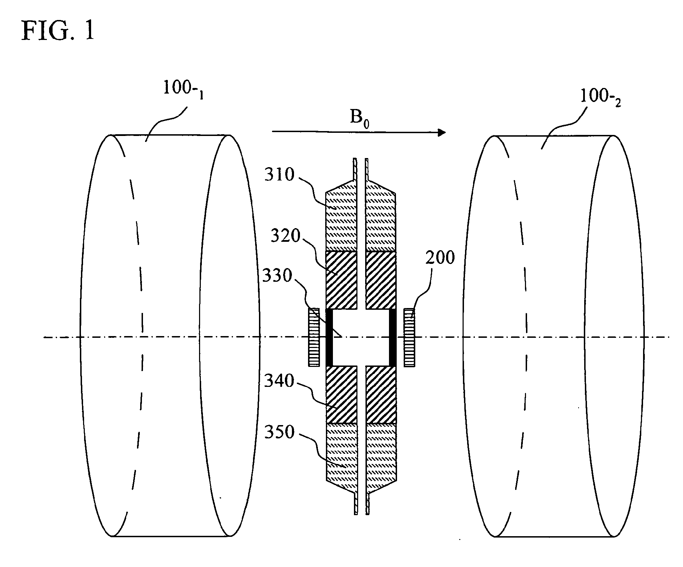

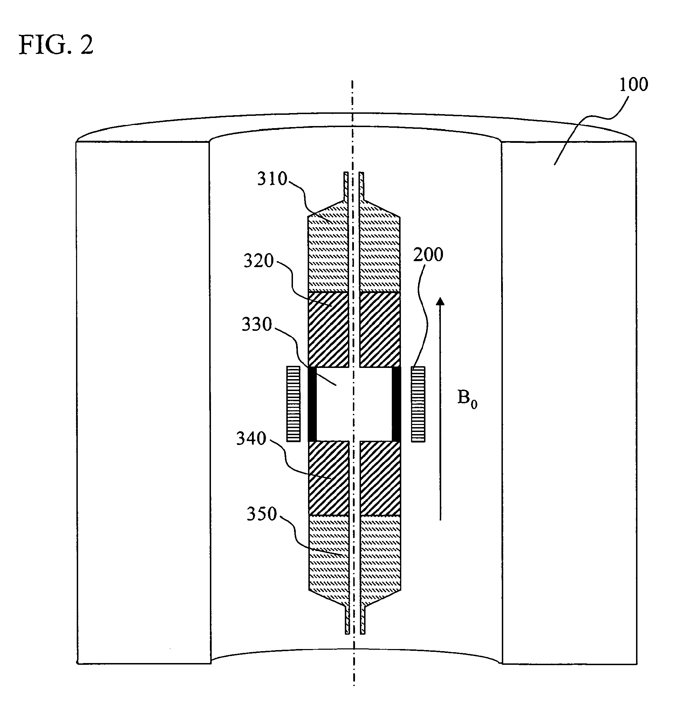

Fig. 1 is a view of the arrangement of a sample tube and an antenna for a split magnet. As shown in Fig. 1, magnets 100 that produce a magnetic field are mounted, and an antenna 200 for detecting a nuclear magnetic resonance signal is mounted in a uniform magnetic field region located in the vicinity of the magnet. Fig. 2 is a view of the arrangement of the sample tube and the antenna for an integral magnet as used as the magnet 100. Even with magnets in varying forms, there is no change in the relative positions of the antenna 200 and the sample tube of the present invention.

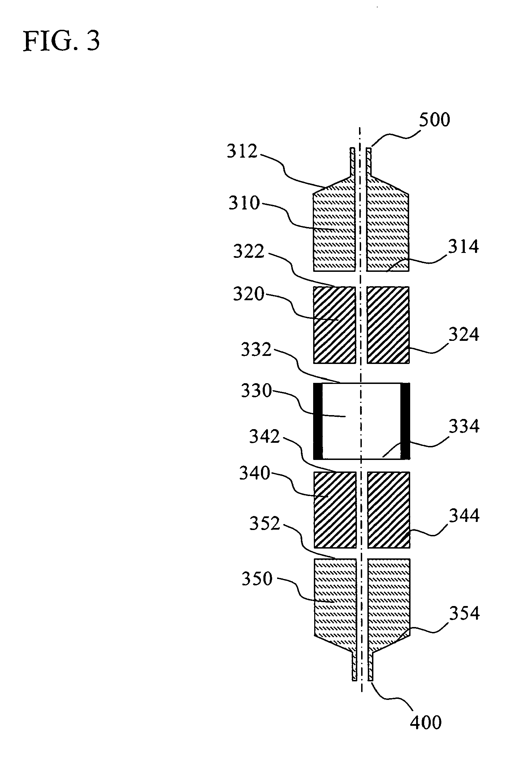

Fig. 3 shows a preferred embodiment of constituent parts of the sample tube. Desirably, a signal detecting tube 330 that accommodates a sample at the position of the antenna 200 has a length lying between 80% and 100% of the length of the antenna 200, and the signal detecting tube 330 has an inlet end 334 and an outlet end 332. The signal detecting tube 330 is disposed in a region between upper and lower ends of the antenna. The outside diameter of the signal detecting tube 330 has a value less than the inside diameter of the antenna 200. As the outside diameter of the signal detecting tube 330 gets closer to the inside diameter of the antenna, a sample volume for use in signal detection becomes greater; however, a value such that the signal detecting tube 330 is in no contact with an inner surface of the antenna can be adopt for the outside diameter from the viewpoint of insertion and withdrawal of the sample tube.

As the signal detecting tube 330 becomes thinner, the strength of the detected signal becomes greater; however, too thin a tube weakens the mechanical strength. When glass or a similar material is used for the signal detecting tube 330, it is preferable that the thickness of the signal detecting tube 330 lies between 0.2 and 0.4 mm, both inclusive. Any material can be used for the signal detecting tube 330, provided that the material can be joined to an NMR-active material having a magnetic susceptibility adjusted to match or approach that of a sample solvent, as is well known in the art, and that the material permits the antenna 200 to detect the NMR signal from the sample; however, it is preferable that glass having a coefficient of thermal expansion matched to that of glass having a magnetic susceptibility adjusted to match or approach that of the sample solvent, be used. The joining of glass tubes with the matched coefficient of thermal expansion (CTE), as mentioned above, is well known technology in the art of glasswork.

The NMR-active material having magnetic susceptibility the same or close to that of the sample solvent required by a measurer, is used for a first joint tube 340, a second joint tube 320 and the signal detecting tube 330, which is intended as within the scope of the present invention. If the NMR-active material having a magnetic susceptibility matched to or brought close to that of the sample solvent, is offset 50% or more from the value of the magnetic susceptibility of the sample solvent, this can cause a large difference in the magnetic susceptibility at an interface and hence render it difficult to adjust a static magnetic field, and it is therefore desirable that the magnetic susceptibility of the NMR-active material be controlled to within plus or minus 50% of the magnetic susceptibility of the sample solvent.

When the sample solvent injected into the sample tube contains mainly any one of water and deuterium oxide, it is preferable that the NMR-active material be the material having the magnetic susceptibility value lying within plus or minus 50%, centered at 0.71 (cgs). When the solvent contains mainly chloroform (which may be deuterated), it is preferable that the NMR-active material be the material having the magnetic susceptibility value lying within plus or minus 50%, centered at 0.74 (cgs). When the solvent contains mainly methanol (which may be deuterated), it is preferable that the NMR-active material be the material having the magnetic susceptibility value lying within plus or minus 50%, centered at 0.53 (cgs).

As shown in Fig. 3, the first joint tube 340 has an outside diameter equal to the outside diameter of the signal detecting tube 330, an inside diameter smaller than the inside diameter of the signal detecting tube 330, and has an inlet end 344 and an outlet end 342. Preferably, the length of the first joint tube 340 lies between 10 and 20 mm, both inclusive, although a longer length of tube has the advantageous effect of yielding a higher degree of magnetic field uniformity in the vicinity of the sample and hence a narrower line width of the NMR signal. The second joint tube 320 has an outside diameter equal to the outside diameter of the signal detecting tube 330, an inside diameter smaller than the inside diameter of the signal detecting tube 330, and has an inlet end 324 and an outlet end 322. Preferably, the length of the second joint tube 320 lies between 10 and 20 mm, both inclusive, although a longer length of tube has the advantageous effect of yielding a higher degree of magnetic field uniformity in the vicinity of the sample and hence a narrower line width of the NMR signal.

Preferably, the inside diameters of the first joint tube 340 and the second joint tube 320 lie between 25 µm and 0.75 mm, both inclusive The inside diameters are set smaller than the inside diameter of the signal detecting tube 330, so that the sample is accommodated in the signal detecting tube 330. The first joint tube 340 and the second joint tube 320 are made of the NMR-active material having a magnetic susceptibility adjusted to match or approach that of the sample solvent, as is well known in the art, to thereby suppress a sharp change in magnetic properties at the interface with the sample accommodated in the signal detecting tube 330.

The sample is in contact with the face of the outlet end 342 of the first joint tube 340, at a joint surface of the outlet end 342 of the first joint tube 340 and the inlet end 334 of the signal detecting tube 330. The sample is in contact with the face of the inlet end 324 of the second joint tube 320, at a joint surface of the inlet end 324 of the second joint tube 320 and the outlet end 332 of the signal detecting tube 330. The face of the outlet end 342 of the first joint tube 340 and the face of the inlet end 324 of the second joint tube 320 are fixed symmetrically with respect to the center of the signal detecting tube 330, and the face of the outlet end 342 of the first joint tube 340 and the face of the inlet end 324 of the second joint tube 320 have the form of any one of a plane surface and a spherical surface.

An injection supporting tube 350 has an inside diameter smaller than the inside diameter of the signal detecting tube 330, an inlet end 354 and an outlet end 352, and has one injection port at the inlet end and one ejection port at the outlet end. An ejection supporting tube 310 has an inside diameter smaller than the inside diameter of the signal detecting tube 330, an inlet end 314 and an outlet end 312, and has one ejection port at the outlet end and one injection port at the inlet end. Preferably, the inside diameters of the injection supporting tube 350 and the ejection supporting tube 310 lie between 25 µm and 0.75 mm, both inclusive, and desirably, they are equal to the inside diameters of the first joint tube 340 and the second joint tube 320.

The outlet end 352 of the injection supporting tube 350 is joined to the inlet end 344 of the first joint tube 340, and the outlet end 342 of the first joint tube 340 is joined to the inlet end 334 of the signal detecting tube 330. In addition, the inlet end 314 of the ejection supporting tube 310 is joined to the outlet end 322 of the second joint tube 320, and the inlet end 324 of the second joint tube 320 is joined to the outlet end 332 of the signal detecting tube 330.

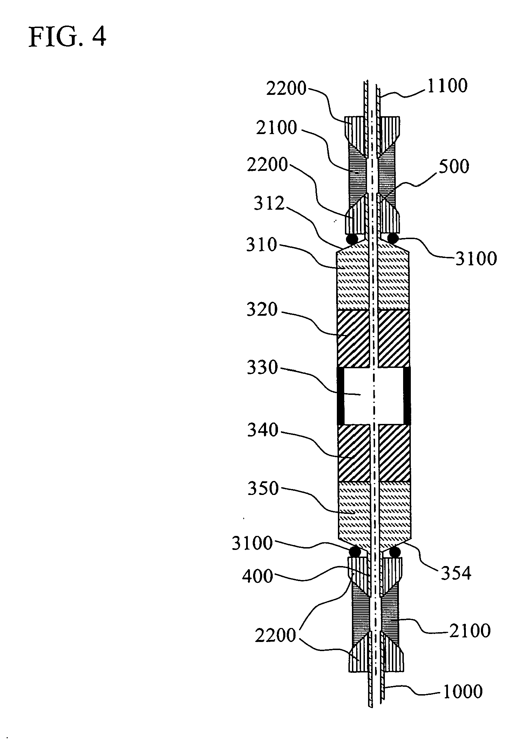

As shown in Fig. 4, an injection port 400 at the inlet end 354 of the injection supporting tube 350 has a form suitable for connection to a tube 1000 for sample injection. One preferred form of the injection port 400 is a tubular form having outside and inside diameters equal to those of the tube 1000 and having a length required for connection using a union and a fitting in general use for HPLC.

An ejection port 500 at the outlet end 312 of the ejection supporting tube 310 has a form suitable for connection to a tube 1100 for sample ejection. One preferred form of the ejection port 500 is a tubular form having outside and inside diameters equal to those of the tube 1100 and having a length required for connection using the union and the fitting in general use for the HPLC.

When the union and the fitting in general use for the HPLC are used to connect the injection port 400 and the tube 1000, an O-ring 3100 can be interposed between the inlet end 354 of the injection supporting tube 350 and a fitting 2200, to prevent damage to the sample tube or the tube 1000 as subjected to transverse stress. Likewise, when the union and the fitting in general use for the HPLC are used to provide a connection between the ejection port 500 and the tube 1100, an O-ring 3100 can be interposed between the outlet end 312 of the ejection supporting tube 310 and a fitting 2200 to prevent damage to the sample tube or the tube 1100 as subjected to transverse stress.

The joining of the signal detecting tube 330, the first joint tube 340, the second joint tube 320, the injection supporting tube 350 and the ejection supporting tube 310 is such that the tubes are axially aligned with one another. For this, one desirable method is to employ tubes with the same diameter.

For the use of the sample tube made by following the above-described procedure, the signal detecting tube 330 is located so as to be covered with the antenna 200, as shown in Fig. 1.

The sample entering at the inlet end 354 of the injection supporting tube 350 flows through the first joint tube 340 joined to the injection supporting tube 350, into the signal detecting tube 330, and through the second joint tube 320, and exits at the outlet end 312 of the ejection supporting tube 310. At this time, the largest portion of the sample accommodated in the sample tube is in the signal detecting tube 330.

The signal detecting tube 330 is in a location covered with the antenna 200, so that the sample is present in a location covered with the antenna 200. This suggests that the sample can be effectively eliminated from a region in which there is a marked deterioration in uniformity in an applied electromagnetic wave from the antenna 200. Consequently, this enables an improvement in the uniformity in the applied electromagnetic wave and hence efficient reception of an FID signal emitted from the sample.

In addition, the magnetic susceptibility of the first joint tube and the second joint tube has a value matching or close to that of the sample solvent, thus making it possible to lessen magnetic discontinuity at the interfaces 342 and 324 and hence maintain the magnetic field uniformity in the vicinity of the sample. This effect leads to the advantageous effect of narrowing a spectral line width obtained from the acquired FID signal.

### [Second embodiment]

Description will be given with reference to the drawing with regard to a preferred embodiment of the configuration of the sample tube described with reference to the first embodiment, in which the injection port of the injection supporting tube 350 and the ejection port of the ejection supporting tube 310 have the form of an internal thread (or a female thread).

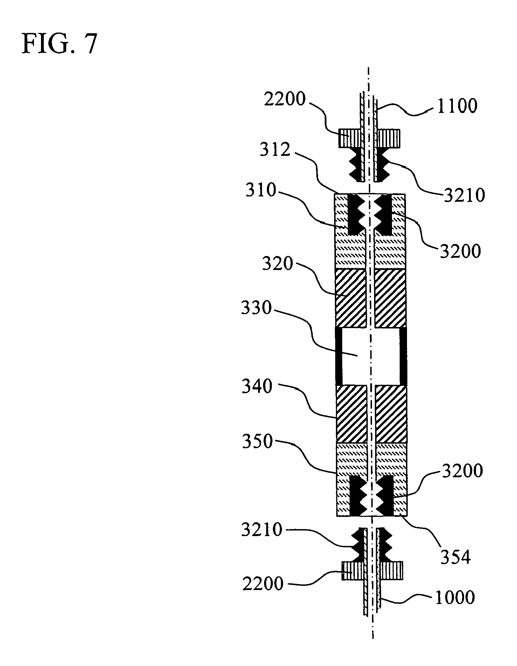

Fig. 7 shows an example of the configuration of the sample tube in which the injection port of the injection supporting tube 350 and the ejection port of the ejection supporting tube 310 have the form of the internal thread (or the female thread). A groove 3200 is cut in the inlet end 354 of the injection supporting tube 350. The groove 3200 is cut with the pitch of threads 3210 of the fitting 2200. Likewise, the thread groove 3200 is cut in the outlet end 312 of the ejection supporting tube 310. The thread groove 3200 is cut with the pitch of the threads 3210 of the fitting 2200.

The tube 1000 is inserted into the fitting 2200, and the fitting 2200 is connected to the injection supporting tube 350. For connection, tape made of a fluorocarbon resin material, or the like may be wound around the threads 3210 to provide sealing. Likewise, the tube 1100 is inserted into the fitting 2200, and the fitting 2200 is connected to the ejection supporting tube 310. For connection, the tape made of the fluorocarbon resin material, or the like may be wound around the threads 3210 to provide sealing.

### [Third embodiment]

In order to achieve the appropriate relative positions of the antenna 200 and the signal detecting tube 330 shown in Figs. 1 and 2,.what is required is a structure in which one of the injection part and the ejection part can pass through the inside of the antenna 200. Description will now be given with reference to the drawing with regard to a preferred embodiment in which any one of the injection supporting tube 350 and the ejection supporting tube 310 has plural ports.

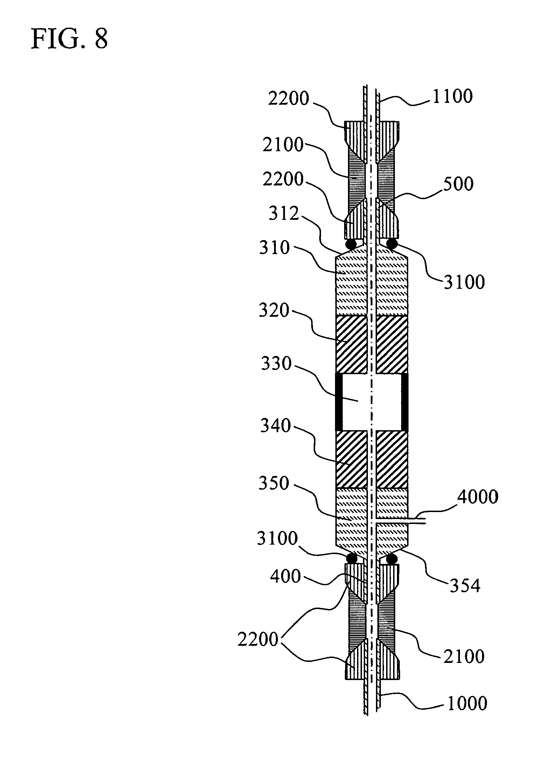

Fig. 8 shows the configuration of the sample tube having the injection supporting tube 350 having plural ports. Besides the tube 1000 for sample injection, a capillary 4000 for the injection of a chemical liquid or the like is connected to the injection supporting tube 350. The capillary is made of a glass material or the like, and desirably, the capillary is externally coated with polyimide or the like. A hole is formed in the side of the injection supporting tube 350, and the capillary 4000 is inserted into the hole and joined to the injection supporting tube 350.

It is required that the inside diameter of the capillary 4000 be smaller than that of the injection supporting tube 350. If the inside diameter of the injection supporting tube 350 is 0.5 mm, it is preferable that the inside diameter of the capillary 4000 be equal to or less than 100 µm. The capillary coated with the polyimide can be flexibly bent, so that the capillary does not prevent operation for effecting the appropriate relative positions of the antenna 200 and the signal detecting tube 330.

The use of this embodiment enables NMR measurement immediately after the injection of the chemical liquid into a sample solution.

In addition, an embodiment of the configuration shown in Fig. 8 in which the capillary 4000 is joined to the ejection supporting tube 310 rather than the injection supporting tube 350 can be used for separation of the sample immediately after the NMR measurement. This embodiment is also intended as within the scope of the present invention.

Application of the present invention to a compound having a given function in a solution, including protein achieves a reduction in the cost of repeated measurements involved in solution conditions. Then, this leads to an improvement in the efficiency of biochemical process analysis in vivo in the field of life science, and to enhancement of the efficiency of disease mechanism analysis or screening based on measurement of the strength of bond with disease-related protein in the medical and pharmaceutical fields.
- 100: ... magnet
- 200: ... antenna
- 310: ... ejection supporting tube
- 312: ... outlet end of ejection supporting tube
- 314: ... inlet end of ejection supporting tube
- 320: ... second joint tube
- 322: ... outlet end of second joint tube
- 324: ... inlet end of second joint tube
- 330: ... signal detecting tube
- 332: ... outlet end of signal detecting tube
- 334: ... inlet end of signal detecting tube
- 340: ... first joint tube
- 342: ... outlet end of first joint tube
- 344: ... inlet end of first joint tube
- 350: ... injection supporting tube
- 352: ... outlet end of injection supporting tube
- 354: ... inlet end of injection supporting tube
- 400: ... injection port
- 500: ... ejection port
- 1000: ... tube for injection
- 1100: ... tube for ejection
- 2100: ... union
- 2200: ... fitting
- 3100: ... O-ring
- 3200: ... thread groove
- 3210: ... threads of fitting
- 4000: ... capillary

## Claims

1. A nuclear magnetic resonance measurement apparatus, comprising:
a magnet that produces a static magnetic field;
an antenna for detecting a nuclear magnetic resonance signal, disposed in the static magnetic field; and
a sample tube,
wherein the sample tube is formed of: a signal detecting tube having a length equal to or less than the length of the antenna, and having an inlet end and an outlet end; a first joint tube having an inside diameter smaller than the inside diameter of the signal detecting tube, and having an inlet end and an outlet end; a second joint tube having an inside diameter smaller than the inside diameter of the signal detecting tube, and having an inlet end and an outlet end; an injection supporting tube having an inlet end and an outlet end, and having at least one injection port at the inlet end and one ejection port at the outlet end; and an ejection supporting tube having an inlet end and an outlet end, and having at least one ejection port at the outlet end and one injection port at the inlet end,
the outlet end of the injection supporting tube is joined to the inlet end of the first joint tube, the outlet end of the first joint tube is joined to the inlet end of the signal detecting tube, the inlet end of the ejection supporting tube is joined to the outlet end of the second joint tube, and the inlet end of the second joint tube is joined to the outlet end of the signal detecting tube, whereby the sample tube is formed, and
the signal detecting tube is disposed in a location covered with the antenna.

2. The nuclear magnetic resonance measurement apparatus according to claim 1, wherein the signal detecting tube has the length equal to, or more than, 80% of the length of the antenna.

3. The nuclear magnetic resonance measurement apparatus according to claim 1, wherein the first and second joint tubes are made of an NMR-active material having a magnetic susceptibility adjusted to within plus or minus 50% of the magnetic susceptibility of a sample solvent injected into the sample tube.

4. The nuclear magnetic resonance measurement apparatus according to claim 1, wherein the sample is in contact with the face of the outlet end of the first joint tube at a joint of the outlet end of the first joint tube and the inlet end of the signal detecting tube, and the sample is in contact with the face of the inlet end of the second joint tube at a joint of the inlet end of the second joint tube and the outlet end of the signal detecting tube.

5. The nuclear magnetic resonance measurement apparatus according to claim 4, wherein the face of the outlet end of the first joint tube and the face of the inlet end of the second joint tube are in the form of any one of a plane surface and a spherical concave surface.

6. The nuclear magnetic resonance measurement apparatus according to claim 3, wherein when the sample solvent injected into the sample tube contains mainly any one of water and deuterium oxide, the NMR-active material is a material having a magnetic susceptibility value lying within plus or minus 50%, centered at 0.71 (cgs).

7. The nuclear magnetic resonance measurement apparatus according to claim 3, wherein when the sample solvent injected into the sample tube contains mainly chloroform (which may be deuterated), the NMR-active material is a material having a magnetic susceptibility value lying within plus or minus 50%, centered at 0.74 (cgs).

8. The nuclear magnetic resonance measurement apparatus according to claim 3, wherein when the sample solvent injected into the sample tube contains mainly methanol (which may be deuterated), the NMR-active material is a material having a magnetic susceptibility value lying within plus or minus 50%, centered at 0.53 (cgs).
